# EUROPEAN PATENT APPLICATION

(11) **EP 4 664 134 A1**
(43) Date of publication of application: **17.12.2025**
(21) Application number: 24832367.7
(22) Date of filing: 20.06.2024
(51) Int. Cl.: G01R 31/68, G01R 19/145, H01R 13/642, H01M 10/42

(54) **CONNECTOR INSPECTION APPARATUS**

(30) Priority: 30.06.2023 KR 20230085228
(71) Applicant: LG Energy Solution, Ltd., Seoul 07335 (KR)
(72) Inventor: YOON, Sang Hyun, Daejeon 34122 (KR); LEE, Chang Hun, Daejeon 34122 (KR)
(74) Representative: Plasseraud IP
(86) International application number: PCT/KR2024/008532
(87) International publication number: WO 2025/005588

(57) **Abstract**

A connector inspection device according to an embodiment of the present disclosure, which is an inspection device connected to a connector of a battery module and inspecting the performance of the connector, may include a first body portion; a second body portion having one surface connected to one surface of the first body portion; a third body portion that has one surface connected to the other surface of the second body portion and includes a detection member connected to the connector and receiving an electrical signal from the connector; and a fourth body portion having one surface facing the other surface of the third body portion, having the detection member located therein, and being movable toward the third body portion, wherein the second body portion, the third body portion and the fourth body portion may be movable along one surface of the first body portion.

## Description

### TECHNICAL FIELD

### CROSS-REFERENCE TO RELATED APPLICATIONS

The present application claims priority to Korean Patent Application No. 10-2023-0085228 filed on June 30, 2023 in the Republic of Korea, the disclosures of which are incorporated herein by reference.

### TECHNICAL FIELD

The present disclosure relates to an inspection device that inspects the performance of a connector installed in a battery module.

### BACKGROUND ART

In order to solve the environmental pollution caused by the use of petroleum resources and the shortage problem of energy sources due to the depletion of petroleum resources, research and development on power generation based on eco-friendly energy sources are in progress. In particular, research on secondary batteries with high utilization due to repeated charge/discharge is being actively conducted, and various aspects such as materials, structures, processes, and stability of secondary batteries are being studied.

In general, types of secondary batteries include nickel cadmium batteries, nickel hydrogen batteries, lithium-ion batteries, and lithium-ion polymer batteries. These secondary batteries are applied and used not only in small products such as digital cameras, P-DVDs, MP3Ps, mobile phones, PDAs, portable game devices, power tools, and E-bikes, but also in large products requiring high power such as electric vehicles or hybrid vehicles, in power storage devices that store surplus generated power or renewable energy, and in power storage devices for backup.

To manufacture such a secondary battery, an electrode active material slurry is first applied to a positive electrode current collector and a negative electrode current collector to manufacture a positive electrode and a negative electrode, which are then stacked on both sides of a separator to form an electrode assembly having a predetermined shape. And, the electrode assembly is accommodated in a battery case, an electrolyte is injected, and then sealed.

A battery module is manufactured by configuring a plurality of secondary batteries manufactured in this way and accommodating them therein. In this case, a control unit is designed to detect the status of the plurality of secondary batteries and control the operation of the plurality of secondary batteries. For example, the control unit receives electrical signals from the plurality of secondary batteries or transmits electrical signals to the plurality of secondary batteries by including a configuration such as a printed circuit board (PCB) or a battery management system (BMS). That is, the control unit receives status information of the secondary battery as an electrical signal and controls the operation of the secondary battery according to an operation situation, or the like. In addition, the control unit may be designed inside a battery pack composed of a plurality of battery modules to control the operation of the plurality of battery modules.

Additionally, a connector is designed to electrically connect the plurality of battery modules and the control unit or to electrically connect between the plurality of battery modules. For example, the connector may include a terminal structurally connected to the outer surface of the battery module and electrically connected to the battery module. That is, the connector may include a structure where it is inserted and coupled, so that a portion of the connector may be designed to be detached from or attached to the battery module.

A problem of the connector malfunctioning may occur in the process of using the connector like this, and a connector inspection device is often used to inspect whether the connector is operating normally. The connector inspection device may be inserted and coupled to the connector and electrically connected thereto, thereby inspecting whether the connector is normally transmitting and receiving electrical signals to and from the battery module.

However, in the process where the connector inspection device is inserted and coupled to the connector, the connector inspection device is not coupled to the connector in the correct position, which often causes problems such as damage to the probe pin of the inspection device or the inspection not being performed properly.

Therefore, in the process of inspecting the performance of the connector, there is a need for an inspection device that can be coupled to the connector in the correct position by adjusting the posture and coupling angle of the inspection device.

### SUMMARY

### TECHNICAL PROBLEM

The present disclosure is directed to providing a connector inspection device that adjusts the coupling position and direction to be coupled to the connector in the correct position.

The present disclosure is also directed to providing a connector inspection device that protects the detection member from external factors before being coupled to the connector and forms the detection member to protrude only when coupled to the connector.

### TECHNICAL SOLUTION

A connector inspection device according to an embodiment of the present disclosure, which is an inspection device connected to a connector of a battery module and inspecting the performance of the connector, may include a first body portion; a second body portion having one surface connected to one surface of the first body portion; a third body portion that has one surface connected to the other surface of the second body portion and includes a detection member connected to the connector and receiving an electrical signal from the connector; and a fourth body portion having one surface facing the other surface of the third body portion, having the detection member located therein, and being movable toward the third body portion, wherein the second body portion, the third body portion and the fourth body portion may be movable along one surface of the first body portion.

The second body portion may include a second body main body having one surface connected to one surface of the first body portion and the other surface connected to one surface of the third body portion; and a coupling portion that protrudes from the second body main body and is inserted and coupled to the first body portion.

The first body portion may include an insertion hole formed through which the coupling portion is inserted, and a free space may be formed between the coupling portion and the insertion hole.

As the coupling portion moves inside the insertion hole by the free space, the second body main body may move along one surface of the first body portion.

The second body main body may be movable in a direction parallel to one surface of the first body portion.

The coupling portion may move inside the insertion hole in a direction perpendicular to the direction of being inserted into the insertion hole.

The fourth body portion may include a fourth body main body having one surface connected to the other surface of the third body portion and being movable toward the third body portion; and a connection portion that protrudes from the other surface of the fourth body main body, has the detection member located therein, and is coupled to the connector.

The third body portion may further include a third body main body having one surface connected to the other surface of the second body portion and the detection member formed on the other surface; and a compression member installed in the third body main body and being elastically compressible by the fourth body main body.

The compression member may be located in a space between the third body main body and the fourth body main body, and as the fourth body portion moves toward the third body portion, the compression member may be elastically compressed by the fourth body main body.

The third body main body may include a compression hole formed through and having the compression member located, and both ends of the compression member may contact the other surface of the second body portion and one surface of the fourth body main body.

The connection portion may include a connection hole formed through which the detection member is inserted.

As the fourth body main body moves toward the third body portion, the detection member may move along the connection hole and may protrude from the outer surface of the connection portion.

The detection member may be connected to the connector in a state where the detection member protrudes from the outer surface of the connection portion.

The second body portion, the third body portion and the fourth body portion may be integrally connected and may move together.

The detection member may have a pin shape.

The connector inspection device according to an embodiment of the present disclosure may further include a circuit board located between the other surface of the second body portion and one surface of the third body portion and electrically connected to the detection member.

### ADVANTAGEOUS EFFECTS

According to a preferred embodiment of the present disclosure, by adjusting the coupling position and direction to be coupled to the connector in the correct position, it is possible to prevent problems such as damage to the detection member or failure to properly perform the inspection.

According to a preferred embodiment of the present disclosure, the detection member is protected from external factors before being coupled to the connector, and the detection member is formed to protrude only when coupled to the connector, thereby preventing a problem that the detection member is damaged upon coupling in advance.

In addition, effects that may be easily predicted by those skilled in the art from configurations according to preferred embodiments of the present disclosure may be included.

### BRIEF DESCRIPTION OF THE DRAWINGS

The accompanying drawings illustrate an exemplary embodiment of the present disclosure and together with the following detailed description, serve to provide a further understanding of the technical aspect of the present disclosure, and thus, the present disclosure should not be construed as being limited to the drawings.
FIG. 1 is a perspective view showing a state where a connector inspection device and a connector are coupled according to an embodiment of the present disclosure.
FIG. 2 is a perspective view of a connector inspection device according to an embodiment of the present disclosure.
FIG. 3 is a cross-sectional view taken along line A-A' in FIG. 2.
FIG. 4 is a perspective view of a fourth body portion before movement according to an embodiment of the present disclosure.
FIG. 5 is a perspective view of a fourth body portion after movement according to an embodiment of the present disclosure.
FIG. 6 is a cross-sectional view taken along line B-B' in FIG. 2.
FIG. 7 is a perspective view of a connector inspection device before coupling according to an embodiment of the present disclosure.
FIG. 8 is a perspective view of a connector inspection device being coupled according to an embodiment of the present disclosure.
FIG. 9 is a perspective view of a connector inspection device after coupling according to an embodiment of the present disclosure.

### DETAILED DESCRIPTION

Hereinafter, preferred embodiments of the present disclosure will be described in sufficient detail with reference to the accompanying drawings to enable persons having ordinary skill in the technical field pertaining to the present disclosure to easily carry out the present disclosure. However, the present disclosure may be embodied in many different forms and is not limited or restricted by the following embodiments.

To clearly describe the present disclosure, an irrelevant description or a detailed description of related known technology that may unnecessarily obscure the gist of the present disclosure is omitted, and in affixing the reference numerals to the elements in each drawing, the identical or similar reference numerals are affixed to the identical or similar elements throughout the specification.

Additionally, it should be understood that the terms or words used in the specification and the appended claims should not be construed as limited to general and dictionary meanings, but rather interpreted based on the meanings and concepts corresponding to the technical aspect of the present disclosure on the basis of the principle that the inventor is allowed to define terms appropriately for the best explanation.

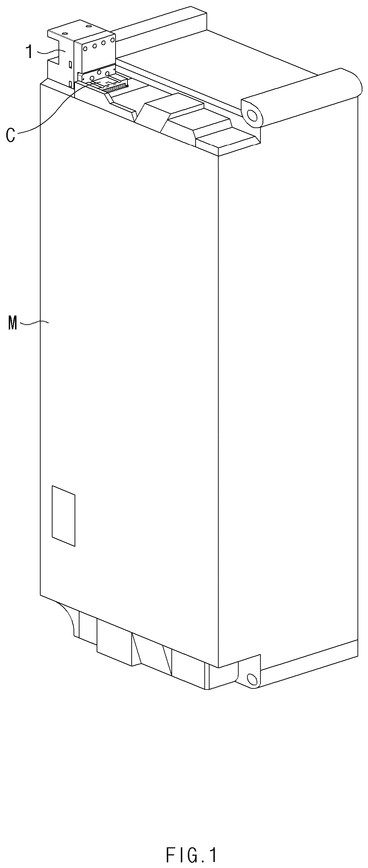

FIG. 1 is a perspective view showing a state where a connector inspection device 1 and a connector C are coupled according to an embodiment of the present disclosure.

Referring to FIG. 1, the connector inspection device 1 according to an embodiment of the present disclosure may be coupled to the connector C and electrically connected to the connector C. The connector inspection device 1 may inspect the performance of the connector C by transmitting and receiving electrical signals to and from the connector C in a state of being inserted and coupled to the connector C. That is, the connector inspection device 1 may inspect whether the connector C operates normally.

Specifically, the connector C may be structurally connected to the outer surface of the battery module M and electrically connected to the battery module M. In other words, the connector C may be designed in a form of being detached from or attached to the battery module M, including the form of a terminal. That is, the connector C may include a female connector C and a male connector C inserted and coupled to the female connector C, and may include a structure in which the male connector C is separated from or inserted into the female connector C.

In this case, the coupling portion, that is, the connection portion, of the connector inspection device 1 may include the same structure as the connection portion of the male connector C, and thus, by being coupled and electrically connected to the female connector C, the performance of the connector C may be inspected.

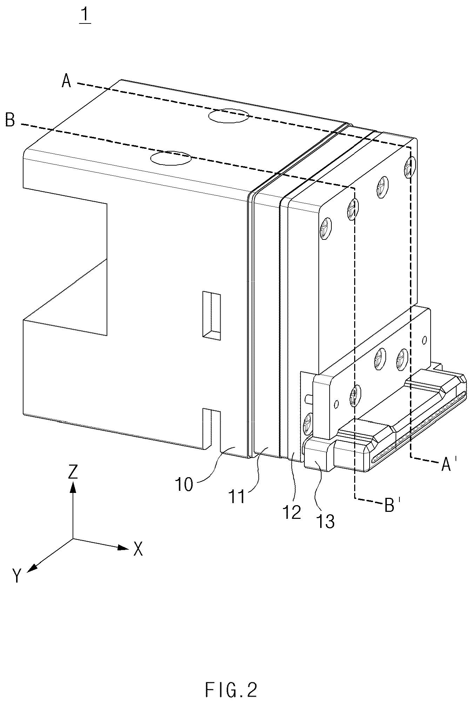

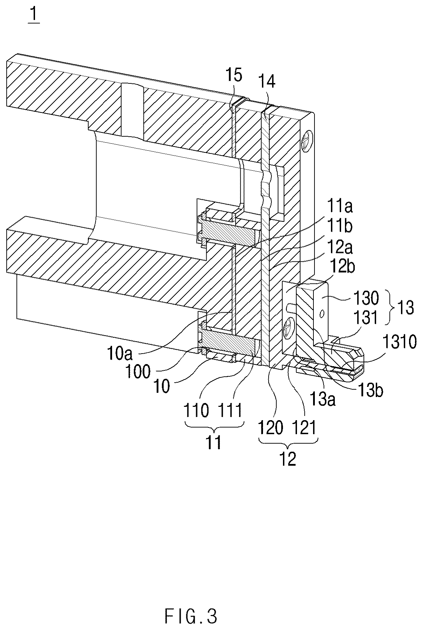

FIG. 2 is a perspective view of the connector inspection device 1 according to an embodiment of the present disclosure, and FIG. 3 is a cross-sectional view taken along line A-A' in FIG. 2.

Referring to FIGS. 2 and 3, the connector inspection device 1 may include a first body portion 10, a second body portion 11, a third body portion 12 and a fourth body portion 13.

The first body portion 10 may be the portion that is farthest away from the connector C. That is, from the first body portion 10, the second body portion 11, the third body portion 12 and the fourth body portion 13 may be sequentially formed toward the connector C. In other words, the first body portion 10 may be the portion that is gripped by the user in the process of coupling the connector inspection device 1 to the connector C.

The second body portion 11 may be connected to the first body portion 10. For example, one surface 11a of the second body portion 11 may be connected to one surface 10a of the first body portion 10, and the other surface 11b of the second body portion 11 may be connected to the third body portion 12 to be described later. That is, the second body portion 11 may be connected to one surface 11a of the first body portion 10 facing the connector C.

The third body portion 12 may be connected to the second body portion 11. For example, one surface 12a of the third body portion 12 may be connected to the other surface 11b of the second body portion 11, and the other surface 12b of the third body portion 12 may be connected to the fourth body portion 13 to be described later.

Additionally, the third body portion 12 may be connected to the connector C. In other words, the third body portion 12 may be electrically connected to the connector C and may receive an electrical signal from the connector C. Specifically, the connector inspection device 1 may move along the X-axis direction, which is the connection direction, and the third body portion 12 may move along the connection direction to be connected to the connector C.

The third body portion 12 may include a third body main body 120 and a detection member 121.

One surface 12a of the third body main body 120 may be connected to the other surface 11b of the second body portion 11. In other words, the third body main body 120 may be connected to the other surface 11b of the second body portion 11 facing the connector C.

The detection member 121 may be connected to the connector C and may receive an electrical signal from the connector C. For example, the detection member 121 may protrude from the other surface 12b of the third body main body 120 toward the connector C. In other words, the detection member 121 may protrude from the other surface 12b of the third body main body 120 along the X-axis direction.

Specifically, the detection member 121 may be formed on the lower side of the other surface 12b of the third body main body 120 to move along the upper surface of the battery module M, and then may be inserted and coupled to the connector C to be electrically connected to the connector C.

The detection member 121 may have a pin shape. In other words, the detection member 121 may include a plurality of probe pins. The probe pin has a structure that becomes thinner and sharper toward the end, and may be electrically connected by contacting the current collection circuit inside the connector C.

The fourth body portion 13 may be connected to the third body portion 12. For example, one surface 13a of the fourth body portion 13 may face the other surface 12b of the third body portion 12. Additionally, the fourth body portion 13 may have the detection member 121 located therein. That is, the fourth body portion 13 may include a structure surrounding the outer side of the detection member 121.

The second body portion 11, the third body portion 12 and the fourth body portion 13 may be movable along one surface 10a of the first body portion 10. The second body portion 11, the third body portion 12 and the fourth body portion 13 may be integrally connected to move together. For example, the second body portion 11, the third body portion 12 and the fourth body portion 13 may be integrally connected by screw coupling or the like to move integrally in the same direction.

Specifically, the second body portion 11, the third body portion 12 and the fourth body portion 13 may move in a direction parallel to one surface 10a of the first body portion 10. Referring to FIG. 2, the second body portion 11, the third body portion 12 and the fourth body portion 13 may move in the Y-axis or Z-axis direction.

More specifically, the second body portion 11 may include a second body main body 110 and a coupling portion 111.

One surface 11a of the second body main body 110 may be connected to one surface 10a of the first body portion 10, and the other surface 11b of the second body main body 110 may be connected to one surface 12a of the third body portion 12. The coupling portion 111 may protrude from the second body main body 110 and may be inserted and coupled to the first body portion 10. For example, the coupling portion 111 may be formed to protrude toward the first body portion 10 so as to penetrate the first body portion 10 in a state of being fitted into the second body main body 110.

The first body portion 10 may include an insertion hole 100 formed through which the coupling portion 111 is inserted. In a state where the coupling portion 111 is inserted into the insertion hole 100, the end of the coupling portion 111 may be connected to the inner surface of the first body portion 10 inside the insertion hole 100.

The coupling portion 111 may move a predetermined distance inside the insertion hole 100. For example, a free space may be formed between the coupling portion 111 and the insertion hole 100. Additionally, the coupling portion 111 may move a predetermined distance along the inner surface of the first body portion 10 in a state of being connected to the inner surface of the first body portion 10 inside the insertion hole 100.

Specifically, the coupling portion 111 may move inside the insertion hole 100 in a direction perpendicular to the direction in which it is inserted into the insertion hole 100. For example, the coupling portion 111 may be inserted into the insertion hole 100 along the X-axis direction and may move a predetermined distance along the Y-axis or Z-axis direction, which is a direction perpendicular to the insertion direction.

A plurality of such structures of the coupling portion 111 and the insertion hole 100 may be formed on one surface 10a of the first body portion 10.

As the coupling portion 111 moves inside the insertion hole 100 by the free space, the second body main body 110 may move along one surface 10a of the first body portion 10. That is, the second body main body 110 may be movable in the Y-axis or Z-axis direction, which is parallel to the one surface 10a of the first body portion 10. At the same time, the third body portion 12 and the fourth body portion 13, which are integrally connected to the second body portion 11, may also move in the same direction.

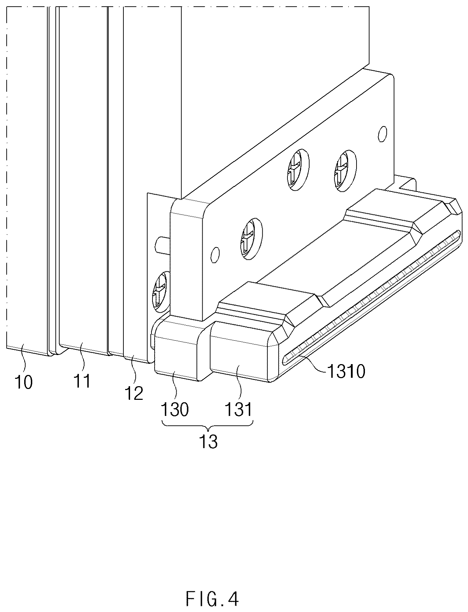

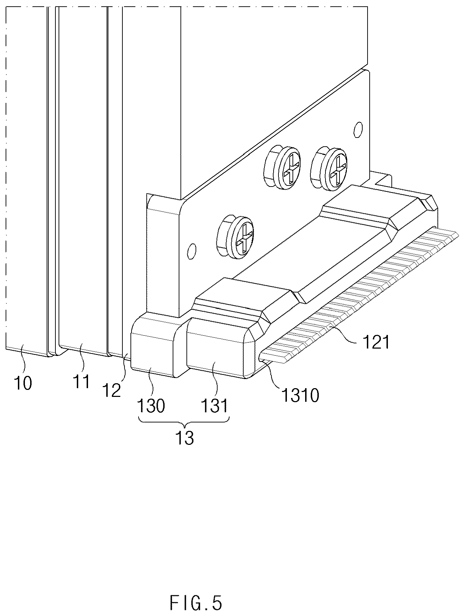

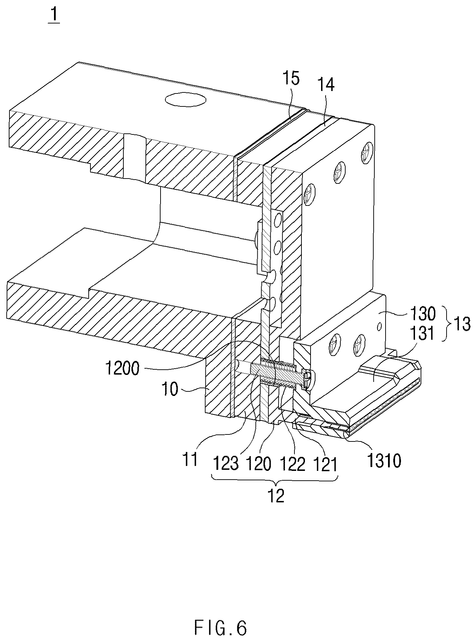

FIG. 4 is a perspective view of the fourth body portion 13 before movement according to an embodiment of the present disclosure, FIG. 5 is a perspective view of the fourth body portion 13 after movement according to an embodiment of the present disclosure, and FIG. 6 is a cross-sectional view taken along line B-B' in FIG. 2.

Referring to FIGS. 4 to 6, the fourth body portion 13 may be movable toward the third body portion 12. In other words, the fourth body portion 13 may move toward the third body portion 12 in a direction parallel to the X-axis direction. For example, the fourth body portion 13 may move in a direction opposite to the direction in which the connector inspection device 1 is connected.

For such movement of the fourth body portion 13, the third body portion 12 may further include a compression member 122 that is installed in the third body main body 120 and elastically compressible by the fourth body main body 130. The compression member 122 may include a spring capable of elastic deformation, be compressively deformed by receiving an external force, and be restored to its original form when the external force is removed.

The compression member 122 may be located in a space between the third body main body 120 and the fourth body main body 130. Specifically, the third body main body 120 may include a compression hole 1200 formed therethrough, and the compression member 122 may be located in the compression hole 1200. Both ends of the compression member 122 may contact the other surface 11b of the second body portion 11 and one surface 13a of the fourth body main body 130.

As the fourth body portion 13 moves toward the third body portion 12, the compression member 122 may be elastically compressed by the fourth body main body 130. That is, in a state where one end of the compression member 122 is in close contact with the other surface 11b of the second body portion 11, the other end of the compression member 122 is subjected to an external force by one surface 13a of the fourth body main body 130, so that the compression member 122 may be elastically deformed in a direction opposite to the connection direction.

The third body portion 12 may further include a support member 123 located inside the compression member 122 and supporting the compression member 122. For example, in a state where the support member 123 is inserted into the compression hole 1200, both ends of the support member 123 may be fixedly coupled to each of the second body portion 11 and the fourth body portion 13.

According to such structure of the support member 123, even if the compression member 122 is elastically deformed in the form of a spring, the compression member 122 may be supported by the support member 123, and thus the compression member 122 may not bend and may not deviate from the deformation path.

The fourth body portion 13 may include a fourth body main body 130 and a connection portion 131.

One surface 13a of the fourth body main body 130 may be connected to the other surface 12b of the third body portion 12 and may be movable toward the third body portion 12. That is, as the connector inspection device 1 is coupled to the connector C in a state where the fourth body main body 130 is spaced apart from the third body portion 12 at a certain distance, the fourth body main body 130 may move toward the third body portion 12. In this case, one surface 13a of the fourth body main body 130 may compressively deform the compression member 122 by applying an external force to the compression member 122.

The connection portion 131 may be coupled to the connector C. For example, the connection portion 131 may protrude from the other surface 13b of the fourth body main body 130 and may have the detection member 121 located therein. In other words, the connection portion 131 may protrude from the other surface 13b of the fourth body main body 130 along the X-axis direction, that is, the connection direction.

The connection portion 131 may include a connection hole 1310 formed through which the detection member 121 is inserted. As the fourth body main body 130 moves toward the third body portion 12, the detection member 121 may move along the connection hole 1310 and protrude from the outer surface of the connection portion 131.

In a state where the detection member 121 protrudes from the outer surface of the connection portion 131, the detection member 121 may be connected to the connector C. That is, in a state where the fourth body portion 13 is in close contact with the third body portion 12 as the compression member 122 is compressed by the fourth body portion 13, the detection member 121 protruding from the outer surface of the connection portion 131 may be connected to the connector C.

The connector inspection device 1 may further include a circuit board 14 located between the other surface of the second body portion 11 and one surface of the third body portion 12 and electrically connected to the detection member 121. The circuit board 14 may be a printed circuit board (PCB). The circuit board 14 may receive an electrical signal related to the performance of the connector C from the detection member 121.

The connector inspection device 1 may further include a tape 15 located between the first body portion 10 and the second body portion 11. The tape 15 may include a Teflon material, and may act to facilitate movement of the second body portion 11 along one surface of the first body portion 10.

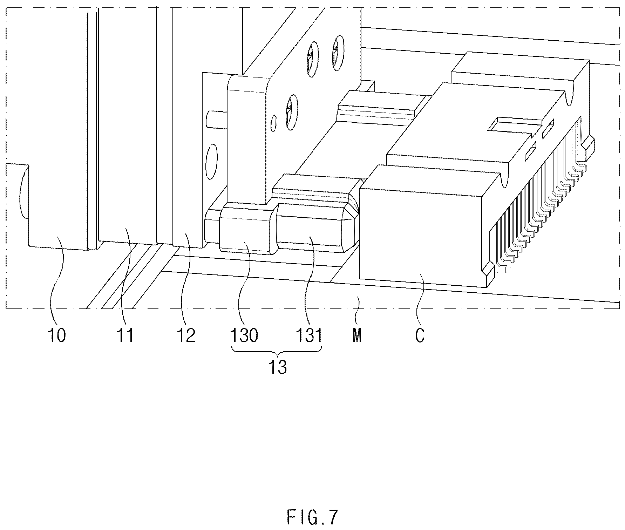

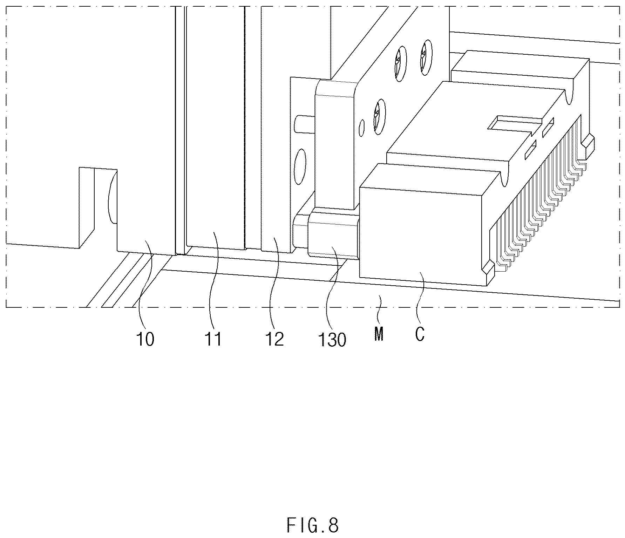

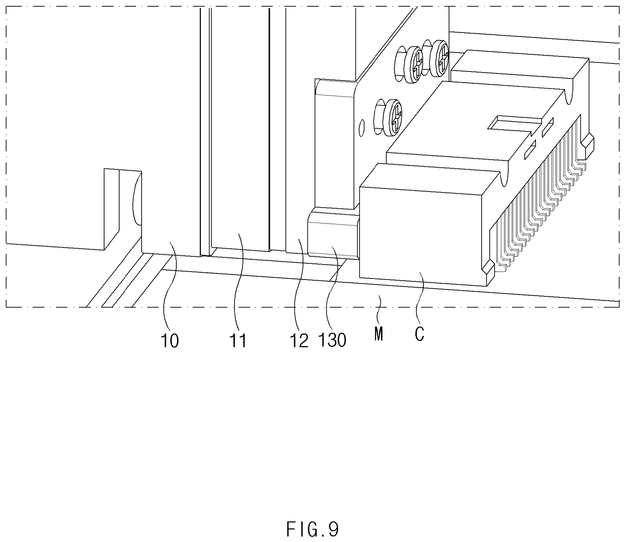

FIG. 7 is a perspective view of the connector inspection device 1 before coupling according to an embodiment of the present disclosure, FIG. 8 is a perspective view of the connector inspection device 1 being coupled according to an embodiment of the present disclosure, and FIG. 9 is a perspective view of the connector inspection device 1 after coupling according to an embodiment of the present disclosure.

In describing a series of processes where the connector inspection device 1 is coupled to the connector C with reference to FIGS. 7 to 9, each edge of the fourth body portion 13 is formed to be inclined, so that the insertion path of the fourth body portion 13 may be adjusted more flexibly in the process of being inserted into the connector C. In this case, the inclined surface of each edge of the connection portion 131 may be formed so that the connection portion 131 becomes narrower along the connection direction.

The fourth body portion 13 may move a predetermined distance in the Y-axis or Z-axis direction, and at the same time, the second body portion 11 and the third body portion 12 that are integrally connected may move a predetermined distance in the Y-axis or Z-axis direction.

Through the edge structure of the fourth body portion 13 and the movable structure of the second body portion 11 to the fourth body portion 13, the connector inspection device 1 may be adjusted in the connection position and may be coupled to the connector C along a predesigned connection path. Therefore, the connector inspection device 1 may be more precisely coupled and connected to the connector C, thereby improving inspection quality and preventing a problem that the inspection is not performed properly.

Next, in the process of the connector inspection device 1 being inserted in contact with the connector C, the fourth body portion 13 receives an external force by the connector C to be pushed in a direction opposite to the connection direction, and the fourth body portion 13 pushed by the connector C may compress the compression member 122 to come into close contact with the third body portion 12.

In this case, the detection member 121 located inside the fourth body portion 13 may protrude to the outside of the fourth body portion 13, thereby being exposed to the outside and being electrically connected by contacting the circuit inside the connector C.

According to this protruding structure of the detection member 121, in a state where the detection member 121 is located inside the fourth body portion 13 prior to coupling, the detection member 121 is designed to protrude outward only when the fourth body portion 13 is normally coupled to the connector C along the connection path, so that the problem of the detection member 121 being damaged during the coupling process may be prevented in advance.

The connector inspection device according to another embodiment of the present disclosure may include only one of a structure in which the second to fourth body portions are movable in the Y-axis or Z-axis direction and a structure in which the fourth body portion is movable toward the third body portion. In other words, the connector inspection device according to another embodiment of the present disclosure may be designed using only one of the two structures depending on the structure and process conditions of the battery module.

The above description is merely an illustrative description of the technical ideas of the present disclosure, and various modifications and variations will be possible by those having ordinary skill in the technical field pertaining to the present disclosure without departing from the essential characteristics of the present disclosure.

Therefore, the embodiments disclosed in the present disclosure are not intended to limit the technical ideas of the present disclosure, but for illustrative purposes, and the scope of the technical ideas of the present disclosure is not limited by these embodiments.

The scope of protection of the present disclosure should be interpreted in accordance with the claims below, and all technical ideas within the scope equivalent thereto should be construed as being included in the scope of the present disclosure.

### [List of Reference Numerals]

1: Connector inspection device
10: First body portion
11: Second body portion
12: Third body portion
13: Fourth body portion
14: Circuit board
15: Tape
10a: One surface of first body portion
11a: One surface of second body portion
11b: The other surface of second body portion
12a: One surface of third body portion
12b: The other surface of third body portion
13a: One surface of fourth body portion
13b: The other surface of fourth body portion
100: Insertion hole
110: Second body main body
111: Coupling portion
120: Third body main body
121: Detection member
122: Compression member
123: Support member
1200: Compression hole
130: Fourth body main body
131: Connection portion
1310: Connection hole

## Claims

1. A connector inspection device, which is an inspection device connected to a connector of a battery module and inspecting the performance of the connector, comprising:
a first body portion;
a second body portion having one surface connected to one surface of the first body portion;
a third body portion that has one surface connected to the other surface of the second body portion and comprises a detection member connected to the connector on the other surface and receiving an electrical signal from the connector; and
a fourth body portion having one surface facing the other surface of the third body portion, having the detection member located therein, and being movable toward the third body portion,
wherein the second body portion, the third body portion and the fourth body portion are movable along one surface of the first body portion.

2. The connector inspection device according to claim 1,
wherein the second body portion comprises:
a second body main body having one surface connected to one surface of the first body portion and the other surface connected to one surface of the third body portion; and
a coupling portion that protrudes from the second body main body and is inserted and coupled to the first body portion.

3. The connector inspection device according to claim 2,
wherein the first body portion comprises an insertion hole formed through which the coupling portion is inserted, and
a free space is formed between the coupling portion and the insertion hole.

4. The connector inspection device according to claim 3,
wherein as the coupling portion moves inside the insertion hole by the free space, the second body main body moves along one surface of the first body portion.

5. The connector inspection device according to claim 4,
wherein the second body main body is movable in a direction parallel to one surface of the first body portion.

6. The connector inspection device according to claim 4,
wherein the coupling portion moves inside the insertion hole in a direction perpendicular to the direction of being inserted into the insertion hole.

7. The connector inspection device according to claim 1,
wherein the fourth body portion comprises:
a fourth body main body having one surface connected to the other surface of the third body portion and being movable toward the third body portion; and
a connection portion that protrudes from the other surface of the fourth body main body, has the detection member located therein, and is coupled to the connector.

8. The connector inspection device according to claim 7,
wherein the third body portion further comprises:
a third body main body having one surface connected to the other surface of the second body portion and the detection member formed on the other surface; and
a compression member installed in the third body main body and being elastically compressible by the fourth body main body.

9. The connector inspection device according to claim 8,
wherein the compression member is located in a space between the third body main body and the fourth body main body, and
as the fourth body portion moves toward the third body portion, the compression member is elastically compressed by the fourth body main body.

10. The connector inspection device according to claim 9,
wherein the third body main body comprises a compression hole formed through and having the compression member located, and
both ends of the compression member contact the other surface of the second body portion and one surface of the fourth body main body.

11. The connector inspection device according to claim 7,
wherein the connection portion comprises a connection hole formed through which the detection member is inserted.

12. The connector inspection device according to claim 11,
wherein as the fourth body main body moves toward the third body portion, the detection member moves along the connection hole and protrudes from the outer surface of the connection portion.

13. The connector inspection device according to claim 12,
wherein the detection member is connected to the connector in a state where the detection member protrudes from the outer surface of the connection portion.

14. The connector inspection device according to claim 1,
wherein the second body portion, the third body portion and the fourth body portion are integrally connected and move together.

15. The connector inspection device according to claim 1,
wherein the detection member has a pin shape.

16. The connector inspection device according to claim 1, further comprising:
a circuit board located between the other surface of the second body portion and one surface of the third body portion and electrically connected to the detection member.
